# EUROPEAN PATENT APPLICATION

(11) **EP 4 676 175 A1**
(43) Date of publication of application: **07.01.2026**
(21) Application number: 24824948.4
(22) Date of filing: 22.03.2024
(51) Int. Cl.: H05K 7/20

(54) **ELECTRONIC DEVICE**

(30) Priority: 21.06.2023 CN 202310746253
(71) Applicant: Honor Device Co., Ltd., Shenzhen, Guangdong 518040 (CN)
(72) Inventor: LV, Yan, Shenzhen, Guangdong 518040 (CN); YAN, Bin, Shenzhen, Guangdong 518040 (CN); ZHANG, Yihe, Shenzhen, Guangdong 518040 (CN); YU, Qianbang, Shenzhen, Guangdong 518040 (CN)
(74) Representative: Thun, Clemens
(86) International application number: PCT/CN2024/083330
(87) International publication number: WO 2024/260046

(57) **Abstract**

This application relates to the field of electronic product technologies, and provides an electronic device, to reduce a possibility of generating a local hotspot on a battery cover when a user holds the electronic device, thereby improving tactile feel and usage comfort, heat dissipation uniformity, and heat dissipation efficiency of the electronic device. The electronic device includes a battery cover and a heating component. The battery cover includes a first surface and a second surface, the first surface forms a partial region of an outer surface of the electronic device, and the second surface faces away from the first surface. The heating component is located on a side that is of the second surface and that faces away from the first surface. At least one groove is disposed on the second surface, and a region occupied by the groove on the second surface overlaps with an orthographic projection region of the heating component on the second surface.

## Description

This application claims priority to Chinese Patent Application No. 202310746253.2, filed with the China National Intellectual Property Administration on June 21, 2023 and entitled "ELECTRONIC DEVICE", which is incorporated herein by reference in its entirety.

### TECHNICAL FIELD

This application relates to the field of electronic product technologies, and in particular, to an electronic device.

### BACKGROUND

Electronic devices such as a mobile phone and a tablet computer have battery covers. The battery cover is configured to protect components in the electronic device, such as a battery, a mainboard, and a camera module. When a user holds the electronic device, a palm contacts the battery cover and can feel heat from the battery cover. A larger amount of heat of the battery cover leads to poorer usage comfort of the user.

As electronic devices (in particular, foldable mobile phones) become increasingly lighter and thinner, a gap between an internal component and a battery cover is increasingly smaller. When holding the electronic device, the user inevitably applies a specific pressure to the battery cover. Under the action of the pressure, the battery cover bends toward an internal space of the electronic device. In this case, the battery cover is easily in contact with an internal heating component to form a thermal conduction path. When the electronic device operates, heat is transmitted to the battery cover along the thermal conduction path. Consequently, the electronic device becomes hot to the touch, and tactile feel and usage comfort of the electronic device are affected. In addition, a local hotspot is formed on the battery cover, resulting in poor heat dissipation uniformity and low heat dissipation efficiency of the electronic device.

### SUMMARY

This application provides an electronic device, to reduce a possibility of generating a local hotspot on a battery cover when a user holds the electronic device, thereby improving tactile feel and usage comfort, heat dissipation uniformity, and heat dissipation efficiency of the electronic device.

To achieve the foregoing objectives, this application provides an electronic device. The electronic device includes a battery cover and a heating component.

The battery cover includes a first surface and a second surface, the first surface forms a partial region of an outer surface of the electronic device, and the second surface faces away from the first surface.

The heating component is located on a side that is of the second surface and that faces away from the first surface.

At least one groove is disposed on the second surface, and a region occupied by the groove on the second surface overlaps with an orthographic projection region of the heating component on the second surface.

Because the region occupied by the groove on the second surface overlaps with the orthographic projection region of the heating component on the second surface, the groove is located on a shortest heat dissipation path from the heating component to the battery cover. In this way, a sidewall of the groove may implement a support function, thereby preventing a bottom wall of the groove from being deformed toward the heating component under the action of pressing during holding by a user. Therefore, a heat conduction path is prevented from being formed on the shortest heat dissipation path, and heat of the heating component is prevented from being directly transmitted to the battery cover along the heat conduction path. Therefore, a possibility of generating a local hotspot on the battery cover is reduced, and tactile feel and usage comfort of the electronic device are improved. In addition, heat dissipation uniformity and heat dissipation efficiency of the electronic device may be further improved by reducing the possibility of generating the local hotspot on the battery cover.

In a possible implementation, a first thermal insulator is disposed in the groove. The first thermal insulator includes but is not limited to at least one of air, thermal insulation silicone rubber, thermal insulation gel, glass wool, and polyurethane. Thermal conductance of the first thermal insulator is low, which can prevent the heat of the heating component from being transmitted to the battery cover along the shortest heat dissipation path, thereby reducing the possibility of generating the local hotspot on the battery cover, and improving heat dissipation uniformity and heat dissipation efficiency.

In a possible implementation, thermal conductivity of the first thermal insulator may be less than thermal conductivity of the battery cover. In this way, the thermal conductivity of the first thermal insulator is low, which can effectively prevent the heat of the heating component from being transmitted to the battery cover along the shortest heat dissipation path.

Optionally, the heating component may be an electronic component that generates heat during operation. For example, the heating component may be a processor, a memory, a BTB connector, a cable connector, or the like. Certainly, the heating component may alternatively be a structural member that transmits heat. For example, the heating component may be a component that is in direct or indirect thermal contact with a heat source component, for example, a shielding cover.

In a possible implementation, the electronic device further includes a circuit board, a first connector, and a second connector.

The circuit board is located on a side that is of the second surface and that is away from the first surface. The first connector is disposed on a surface that is of the circuit board and that faces the battery cover. The second connector is located between the first connector and the battery cover and is connected to the first connector in a mating manner, and the second connector forms the heating component.

Because a height by which a connector assembly including the first connector and the second connector protrudes from the circuit board is large, and a distance between the second connector and the battery cover is short, the shortest heat dissipation path has a small length, and heat of the second connector is easily transmitted to the battery cover.

In addition, because an area occupied by the connector assembly including the first connector and the second connector on the circuit board is small, the heat of the second connector is easily concentrated and transmitted to a local region of the battery cover, resulting in the local hotspot on the battery cover. Consequently, the local region of the battery cover becomes hot to the touch, and tactile feel and usage comfort of the electronic device are affected.

Based on this, the groove may be used to effectively prevent the heat of the second connector from being transmitted to the battery cover, thereby effectively reducing a risk that the local hotspot occurs on the battery cover, and effectively improving heat dissipation uniformity.

Optionally, the first connector and the second connector are BTB connectors or radio frequency connectors.

In a possible implementation, the groove is formed through recession of the second surface toward the first surface. In this way, the groove is recessed inward on the battery cover. Therefore, an internal space of the battery cover is used to form the groove, to avoid accumulation of thicknesses of the groove and the battery cover, thereby facilitating thinning of a thickness of the electronic device.

In a possible implementation, the electronic device further includes at least one ring-shaped flange. The at least one ring-shaped flange is disposed on the second surface, and a partial space enclosed by the ring-shaped flange and a part that is of the battery cover and that is surrounded by the ring-shaped flange forms the groove. In this way, the groove is disposed outside the battery cover, to prevent the groove from affecting structural strength of the battery cover.

In a possible implementation, the groove may further include a first groove part and a second groove part.

The first groove part is formed through recession of the second surface toward the first surface, the second groove part is formed by a partial space surrounded by the ring-shaped flange, and the second groove part is opposite to and in communication with the first groove part.

In this way, on a premise that the groove has a specific depth, a depth of a part of the groove inside the battery cover is small, thereby ensuring structural strength of the battery cover. In addition, a distance by which the ring-shaped flange protrudes from the second surface is small, so that an accumulated thickness can be reduced, thereby facilitating thinning of the thickness of the electronic device.

In a possible implementation, an orthographic projection area of the heating component on the second surface is a first area, and an area occupied by the groove on the second surface is a second area. The second area is greater than or equal to 1/10 times the first area, and is less than or equal to 5 times the first area. Specifically, the second area may be 1/10, 1/5, 1, 2, 3, 4, or 5 times the first area.

In this way, an area of the groove is moderate, thereby effectively ensuring a thermal insulation effect and improving tactile feel of the electronic device.

In a possible implementation, at least one flange is disposed at a bottom surface of the groove. The flange may extend along a straight line, a curved line, or a ring-shaped line. This is not specifically limited in this application. The at least one flange may be used to further implement the support function, thereby preventing the bottom wall of the groove from being deformed toward the heating component under the action of pressing during holding by the user.

In a possible implementation, there are a plurality of grooves, and the plurality of grooves are arrayed on the second surface.

In this way, on a premise that a preset region on the second surface for disposing the grooves has a specific area, when the plurality of grooves are disposed in the preset region, an area occupied by each groove on the second surface is small.

When the groove is recessed inward on the battery cover, compared with a solution in which one groove is disposed in the preset region, the solution in which the plurality of grooves are disposed can ensure structural strength of the battery cover because a volume occupied by the grooves in the battery cover is small.

When the sidewall of the groove is formed by the ring-shaped flange, a quantity of ring-shaped flanges is large, so that support performance for the battery cover is good, thereby effectively preventing the battery cover from being bent toward the heating component under the action of a pressure.

In a possible implementation, a depth of the groove is greater than or equal to 0.01 mm and less than or equal to 0.4 mm. Specifically, the depth of the groove may be 0.01 mm, 0.05 mm, 0.08 mm, 0.1 mm, 0.2 mm, 0.3 mm, or 0.4 mm.

When the depth of the groove is within this range, a height of the sidewall of the groove is moderate, so that an effective support function can be implemented, to prevent the bottom wall of the groove from being deformed toward the heating component under the action of pressing during holding by the user.

In addition, when the groove is recessed inward on the battery cover, the depth for inward recession of the groove is moderate, and structural strength of the battery cover is good. When the sidewall of the groove is formed by the ring-shaped flange, a height by which the ring-shaped flange protrudes from the second surface is moderate, and the accumulated thickness of the groove and the battery cover is moderate, thereby facilitating thinning of the thickness of the electronic device.

In a possible implementation, a part of the region occupied by the groove on the second surface is located in the orthographic projection region of the heating component on the second surface, and the other part of the region occupied by the groove on the second surface is located outside the orthographic projection region of the heating component on the second surface. In this way, a part of the battery cover that forms an edge of the groove or a part of the ring-shaped flange that forms an edge of the groove is only partially or is not located on the shortest heat dissipation path. Under the action of the pressure of the user, only a small amount of heat or virtually no heat is transmitted along the shortest heat dissipation path. Therefore, the local hotspot can be effectively prevented from being generated on the battery cover.

In a possible implementation, the electronic device further includes a press-fit bracket, where the press-fit bracket is located between the heating component and the battery cover, and the press-fit bracket is fixedly connected to the circuit board.

A position of the heating component relative to the circuit board may be limited by the press-fit bracket, thereby improving structural stability.

In a possible implementation, the region occupied by the groove on the second surface is a first region, and an orthographic projection region of the press-fit bracket on the second surface is a second region. At least a partial section of a contour of the first region is located in the second region, and is spaced from a contour of the second region.

In this way, the part of the battery cover that forms the edge of the groove or the part of the ring-shaped flange that forms the edge of the groove may be at least partially supported on the press-fit bracket to form stable support for the battery cover, thereby preventing the battery cover from being bent toward the heating component under the action of an external pressure, and preventing the battery cover from being in thermal contact with the heating component.

In a possible implementation, a partial section of the contour of the first region is located in the second region and is spaced from the contour of the second region, and still another partial section of the contour of the first region is located outside the second region and is spaced from the contour of the second region. In this way, the part of the battery cover that forms the edge of the groove or the part of the ring-shaped flange that forms the edge of the groove is only partially located on a shortest heat dissipation path from the press-fit bracket to the battery cover. Under the action of the pressure of the user, only a small amount of heat is transmitted along the shortest heat dissipation path from the press-fit bracket to the battery cover. Therefore, the local hotspot can be effectively prevented from being generated on the battery cover. In addition, the groove and the press-fit bracket may be prevented from enclosing a closed space, thereby preventing internal air from being expanded due to heating, and further avoiding a local defect on the battery cover.

Optionally, the contour of the first region includes a first section and a second section, the first section is located in the second region and is spaced from the contour of the second region, and the second section is located outside the second region.

Both the first section and the second section do not include intersection points between the contour of the first region and the contour of the second region. In this way, a part of the battery cover that forms the first section or a part of the ring-shaped flange that forms the first section may be supported on the press-fit bracket to form stable support for the battery cover, thereby preventing the battery cover from being bent toward the heating component under the action of the external pressure.

In addition, because the second section is located outside the second region, a part of the battery cover that forms the second section or a part of the ring-shaped flange that forms the second section is not located on the shortest heat dissipation path from the press-fit bracket to the battery cover. Under the action of the pressure of the user, only a small amount of heat is transmitted along the shortest heat dissipation path from the press-fit bracket to the battery cover. Therefore, the local hotspot can be effectively prevented from being generated on the battery cover.

Optionally, the contour of the first region includes a first section and a second section. Optionally, the first section and the second section are located on two opposite sides of a geometric center of the first region, and the first section and the second section are located in the second region and are spaced from the contour of the second region.

In this way, two parts of the battery cover that respectively form the first section and the second section or two parts of the ring-shaped flange that respectively form the first section and the second section may be supported on the press-fit bracket.

In addition, because the first section and the second section are located on the two opposite sides of the geometric center of the first region, the two parts of the battery cover that respectively form the first section and the second section or the two parts of the ring-shaped flange that respectively form the first section and the second section are also located on the two opposite sides of the geometric center of the first region, so that a support force for the battery cover is more balanced, thereby effectively preventing the battery cover from being bent toward the heating component under the action of the external pressure.

Optionally, the first region is located in the second region, and the contour of the first region is spaced from the contour of the second region.

In this way, a part of the battery cover that encloses the groove or the ring-shaped flange that encloses the groove is entirely supported on the press-fit bracket, which has a good support effect on the battery cover, thereby effectively preventing the battery cover from being bent toward the heating component under the action of the external pressure.

In a possible implementation, at least one thermal insulation through hole is disposed on the press-fit bracket. The at least one thermal insulation through hole may be used to prevent the heat of the heating component from being transmitted to the battery cover, thereby further reducing the possibility of generating the local hotspot on the battery cover.

Optionally, a second thermal insulator is disposed in the thermal insulation through hole, and thermal conductivity of the second thermal insulator is less than thermal conductivity of the press-fit bracket. The second thermal insulator includes but is not limited to at least one of air, thermal insulation silicone rubber, thermal insulation gel, glass wool, and polyurethane. Thermal conductance of the second thermal insulator is low, which can prevent the heat of the heating component from being transmitted to the battery cover, thereby reducing the possibility of generating the local hotspot on the battery cover, and improving heat dissipation uniformity and heat dissipation efficiency.

In a possible implementation, there are a plurality of thermal insulation through holes. The plurality of thermal insulation through holes are arrayed on the press-fit bracket.

In this way, on a premise that a region for disposing the thermal insulation through holes has a specific area, compared with a solution in which one thermal insulation through hole is disposed, the solution in which the plurality of thermal insulation through holes are disposed can ensure structural strength of the press-fit bracket because an area for disposing each thermal insulation through hole is small.

In a possible implementation, there are a plurality of grooves, the plurality of grooves are arrayed on the second surface, and orthographic projections of the plurality of thermal insulation through holes on the second surface are arranged, in a staggered manner, with regions occupied by the plurality of grooves on the second surface.

That is, geometric centers of the orthographic projections of the plurality of thermal insulation through holes on the second surface do not respectively overlap with geometric centers of the regions occupied by the plurality of grooves on the second surface, and at least a part of the orthographic projection of the thermal insulation through hole on the second surface is located outside the region occupied by the groove on the second surface.

In this way, an area of a thermal insulation layer is greater than a sum of areas of the plurality of thermal insulation through holes, and the area of the thermal insulation layer is further greater than a sum of areas of the plurality of grooves. Therefore, the area of the thermal insulation layer can be increased, and thermal insulation performance can be improved.

Optionally, the orthographic projection of the thermal insulation through hole on the second surface may be entirely located outside the region occupied by the groove on the second surface.

In this way, an area of a thermal insulation layer is a sum of areas of the plurality of thermal insulation through holes and areas of the plurality of grooves. Therefore, the area of the thermal insulation layer can be maximized by using the plurality of grooves and the plurality of thermal insulation through holes, and thermal insulation performance can be improved.

In addition, density for disposing the grooves on the battery cover may be small, and density for disposing the thermal insulation through holes on the press-fit bracket may be small, so that structural strength of the battery cover and the press-fit bracket can be ensured.

In a possible implementation, at least one thermal insulation blind hole is disposed on a surface that is of the press-fit bracket and that faces the battery cover or a surface that is of the press-fit bracket and that faces the heating component. The at least one thermal insulation blind hole may also be used to prevent the heat of the heating component from being transmitted to the battery cover, thereby further reducing the possibility of generating the local hotspot on the battery cover.

In a possible implementation, the electronic device further includes a heat sink, where the heat sink is disposed between the press-fit bracket and the groove, and an orthographic projection area of the heat sink on the second surface is greater than an area of the region occupied by the groove on the second surface.

In this way, the heat sink may be used to transmit, along a plane parallel to the battery cover, the heat of the heating component outward beyond a region in which the groove is located, to prolong a thermal conduction path, thereby avoiding heat concentration, preventing the local hotspot from being generated on the battery cover, improving heat dissipation uniformity, and implementing good heat dissipation performance.

Optionally, a material of the heat sink is graphene or graphite.

Optionally, the electronic device is a foldable mobile phone.

Optionally, the foldable mobile phone includes an inner screen camera, and the second connector is a connector of the inner screen camera.

### BRIEF DESCRIPTION OF DRAWINGS

FIG. 1 is a three-dimensional view of an electronic device according to some embodiments of this application;
FIG. 2 is a three-dimensional view of the electronic device shown in FIG. 1 as seen from a direction D1;
FIG. 3 is a schematic diagram of a structure when a first screen in the electronic device shown in FIG. 1 is in a folded state;
FIG. 4 is a schematic diagram of a cross-sectional structure of the electronic device shown in FIG. 1 in a direction A-A;
FIG. 5 is an assembly diagram of a circuit board, a first connector, a second connector, and a press-fit bracket in the electronic device shown in FIG. 4;
FIG. 6 is a schematic diagram of a structure of a battery cover at a second surface in the electronic device shown in FIG. 4;
FIG. 7 is a schematic diagram of a position of a region occupied by a groove on a second surface relative to an orthographic projection region of a heating component on the second surface in the electronic device shown in FIG. 4;
FIG. 8 is a schematic diagram of still another cross-sectional structure of the electronic device shown in FIG. 1 in a direction A-A;
FIG. 9 is a schematic diagram of a position of a region occupied by a groove on a second surface relative to an orthographic projection region of a press-fit bracket on the second surface in the electronic device shown in FIG. 4;
FIG. 10 is a schematic diagram of still another position of a region occupied by a groove on a second surface relative to an orthographic projection region of a press-fit bracket on the second surface in the electronic device shown in FIG. 4;
FIG. 11 is a schematic diagram of still another position of a region occupied by a groove on a second surface relative to an orthographic projection region of a press-fit bracket on the second surface in the electronic device shown in FIG. 4;
FIG. 12 is a schematic diagram of still another structure of a battery cover at a second surface in the electronic device shown in FIG. 4;
FIG. 13 is a schematic diagram of still another cross-sectional structure of the electronic device shown in FIG. 1 in a direction A-A;
FIG. 14 is a schematic diagram of a structure of a press-fit bracket according to some embodiments of this application; and
FIG. 15 is a schematic diagram of a cross-sectional structure of an electronic device according to still some embodiments of this application.

### DESCRIPTION OF EMBODIMENTS

In the embodiments of this application, terms "first", "second", "third", and "fourth" are used for descriptive purposes only, and cannot be construed as indicating or implying relative importance or implicitly indicating a quantity of indicated technical features. Therefore, features defined with "first", "second", "third", and "fourth" may explicitly or implicitly include one or more of the features.

In the embodiments of this application, the term "include", "comprise", or any other variant thereof is intended to cover non-exclusive inclusion, so that a process, method, article, or apparatus that includes a series of elements not only includes those elements, but also includes other elements that are not explicitly listed, or includes elements inherent to such a process, method, article, or apparatus. Without further limitation, an element defined by the sentence "including a..." does not exclude existence of other identical elements in the process, method, article, or apparatus including the element.

An embodiment of this application provides an electronic device. The electronic device may be user equipment (user equipment, UE), a terminal (terminal) device, or the like. For example, the electronic device may be a mobile terminal or a fixed terminal, for example, a portable android device (portable android device, PAD), a personal digital assistant (personal digital assistant, PDA), a handheld device with a wireless communication function, a computing device, a vehicle-mounted device, a wearable device, a virtual reality (virtual reality, VR) terminal device, an augmented reality (augmented reality, AR) terminal device, a wireless terminal in industrial control (industrial control), a wireless terminal in self driving (self driving), a wireless terminal in remote medical (remote medical), a wireless terminal in a smart grid (smart grid), a wireless terminal in transportation safety (transportation safety), a wireless terminal in a smart city (smart city), or a wireless terminal in a smart home (smart home). A form of the electronic device is not specifically limited in this embodiment of this application.

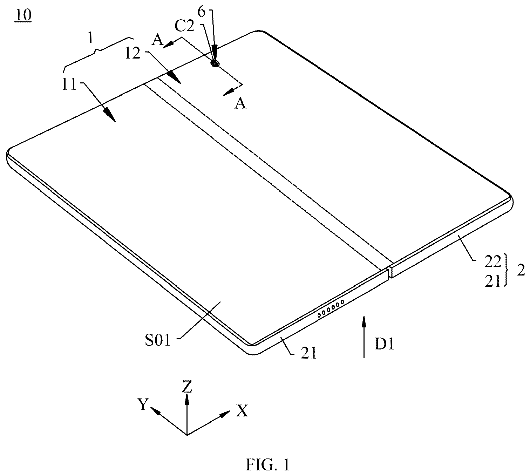

Refer to FIG. 1. FIG. 1 is a three-dimensional view of an electronic device 10 according to some embodiments of this application. This embodiment and the following embodiments are described by using an example in which the electronic device 10 is a foldable-screen device. The foldable-screen device may be, for example, a foldable mobile phone. In FIG. 1, the foldable-screen device is in an unfolded state. In this state, the electronic device is approximately in a shape of a rectangular flat plate. Based on this, for ease of description in the following embodiments, an XYZ coordinate system is established for the electronic device 10 in the unfolded state, a length direction of the electronic device 10 is defined as an X-axis direction, a width direction of the electronic device 10 is defined as a Y-axis direction, and a thickness direction of the electronic device 10 is defined as a Z-axis direction. It can be understood that the coordinate system of the electronic device 10 may be flexibly set based on an actual requirement. This is not specifically limited herein. In some other embodiments, when the electronic device 10 is in the unfolded state, the electronic device 10 may alternatively be in a shape of a square flat plate, a circular flat plate, an elliptical flat plate, or the like.

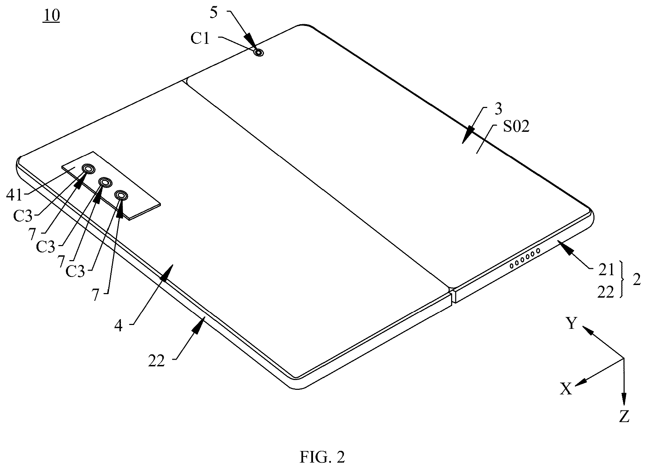

Refer to FIG. 1 and FIG. 2. FIG. 2 is a three-dimensional view of the electronic device 10 shown in FIG. 1 as seen from a direction D1. The electronic device 10 includes a first screen 1, a support apparatus 2, a second screen 3, a battery cover 4, an outer screen camera 5, an inner screen camera 6, and at least one rear-facing camera 7.

It can be understood that FIG. 1 and FIG. 2 schematically show some components included in the electronic device 10. Actual shapes, actual sizes, actual positions, and actual constructions of these components are not limited by those in FIG. 1 and FIG. 2. In some other embodiments, the electronic device 10 may alternatively not include at least one of these components.

Specifically refer to FIG. 1. The first screen 1 may also be referred to as an inner screen, which is configured to display information such as an image or a video. The first screen 1 may be an organic light-emitting diode (organic light-emitting diode, OLED) screen, a micro organic light-emitting diode (micro organic light-emitting diode) screen, a quantum dot light-emitting diode (quantum dot light emitting diode, QLED) screen, or the like.

The first screen 1 includes a display surface S01. A user can see, from the display surface S01, the image or the video displayed by the first screen 1. The first screen 1 has a back side. The back side is a side that is of the first screen 1 and that faces away from the display surface S01.

The support apparatus 2 is located on the back side of the first screen 1, and is fastened to the first screen 1. The support apparatus 2 is configured to support the first screen 1 and protect internal components.

In some embodiments, the support apparatus 2 includes a first middle frame 21 and a second middle frame 22. When the electronic device 10 is another product, the electronic device 10 may alternatively not include the second middle frame 22, or may include, in addition to the first middle frame 21 and the second middle frame 22, a third middle frame, a fourth middle frame, a fifth middle frame, or the like, to form a tri-fold, quad-fold, or penta-fold foldable-screen device. This is not specifically limited in this application.

The first middle frame 21 and the second middle frame 22 are configured to support the first screen 1. Specifically refer to FIG. 1. The first screen 1 includes a first screen part 11 and a second screen part 12. The first screen part 11 is supported on the first middle frame 21, and the second screen part 12 is supported on the second middle frame 22.

Specifically refer to FIG. 2. The second screen 3 may also be referred to as an outer screen. The second screen 3 is disposed on a side that is of the first middle frame 21 and that faces away from the first screen part 11. The second screen 3 includes a display surface S02. The display surface S02 of the second screen 3 faces away from a display surface of the first screen part 11. The display surface of the first screen part 11 is a partial region that is of the display surface S01 and that is located in the first screen part 11.

There is a first accommodating cavity between the second screen 3 and the first middle frame 21. The first accommodating cavity is configured to accommodate components such as a battery, a circuit board, the outer screen camera 5, a speaker module, and an antenna. A light-incident surface of the outer screen camera 5 faces the second screen 3. A first light transmission port C1 is disposed on the second screen 3. The light-incident surface of the outer screen camera 5 is opposite to the first light transmission port C1.

In some other embodiments, the second screen 3 may be replaced with a battery cover. This is not specifically limited in this application.

Specifically refer to FIG. 2. The battery cover 4 may also be referred to as a back cover. The battery cover 4 is disposed on a side that is of the second middle frame 22 and that faces away from the second screen part 12. There is a second accommodating cavity between the battery cover 4 and the second middle frame 22. The second accommodating cavity is configured to accommodate components such as a battery, a circuit board, the inner screen camera 6, and the rear-facing camera 7.

Specifically refer to FIG. 1. A light-incident surface of the inner screen camera 6 faces the first screen 1. A second light transmission port C2 is disposed on the first screen 1. The light-incident surface of the inner screen camera 6 is opposite to the second light transmission port C2. Specifically refer to FIG. 2. A light-incident surface of the at least one rear-facing camera 7 faces the battery cover 4. A camera decorative member 41 is disposed at a position that is on the battery cover 4 and that corresponds to the at least one rear-facing camera 7. The camera decorative member 41 protrudes outward to enlarge a mounting space for the rear-facing camera 7 in the Z-axis direction. In another embodiment, the camera decorative member 41 may alternatively be flush with the battery cover 4 or protrude inward. At least one third light transmission port C3 is disposed on the camera decorative member 41. The at least one third light transmission port C3 is respectively opposite to the light-incident surface of the at least one rear-facing camera 7. In the embodiment shown in FIG. 2, there are three rear-facing cameras 7 and three third light transmission ports C3.

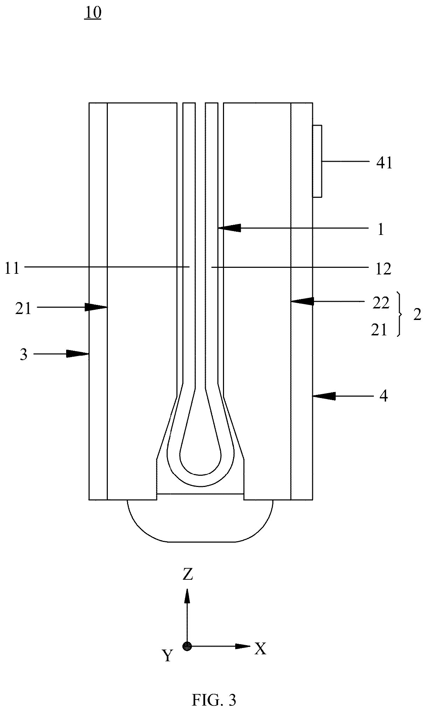

The support apparatus 2 further includes a rotating shaft mechanism. The first middle frame 21 and the second middle frame 22 are rotatably connected by using the rotating shaft mechanism, so that the first screen 1 can be folded from the unfolded state shown in FIG. 1 to a folded state. In FIG. 1, the first screen 1 is in the unfolded state. Refer to FIG. 3. FIG. 3 is a schematic diagram of a structure when the first screen 1 in the electronic device 10 shown in FIG. 1 is in the folded state. In this state, the first middle frame 21 and the second middle frame 22 are approximately stacked, and the first screen 1 is located between the first middle frame 21 and the second middle frame 22. The first screen 1 can be protected by the first middle frame 21 and the second middle frame 22, to prevent the first screen 1 from being scratched, and the electronic device 10 is folded and easily carried. In addition, the second screen 3 is exposed, and small-screen display may be implemented by using the second screen 3.

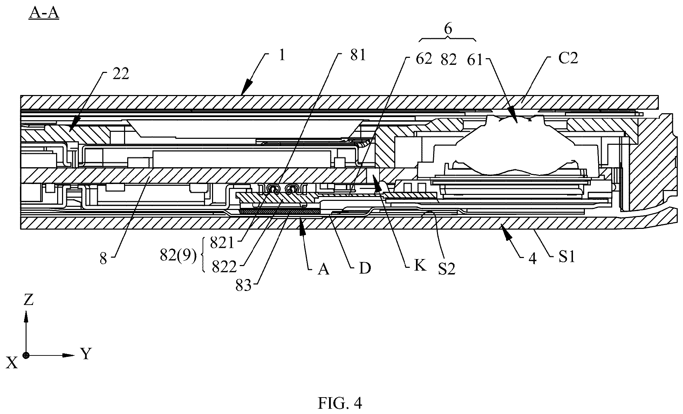

Refer to FIG. 4. FIG. 4 is a schematic diagram of a cross-sectional structure of the electronic device 10 shown in FIG. 1 in a direction A-A. The battery cover 4 includes a first surface S1 and a second surface S2. The first surface S1 forms a partial region of an outer surface of the electronic device 10, the second surface S2 faces away from the first surface S1, and the second surface S2 faces the second accommodating cavity.

Based on this, continue to refer to FIG. 4. The electronic device 10 further includes a circuit board 8, a first connector 81, a second connector 82, and a press-fit bracket 83.

The circuit board 8 is located on a side that is of the second surface S2 and that faces away from the first surface S1. Specifically, the circuit board 8 may be accommodated in the second accommodating cavity. The circuit board 8 is configured to integrate electronic components and implement electrical connection between the electronic components. The circuit board 8 may be a rigid circuit board, a flexible circuit board, or a rigid-flexible circuit board. In some embodiments, the circuit board 8 may be a rigid circuit board. Specifically, the circuit board 8 may be a printed circuit board (printed circuit board, PCB).

The first connector 81 is disposed on a surface that is of the circuit board 8 and that faces the battery cover 4. The first connector 81 may be a board-to-board (board-to-board, BTB) connector, or may be a radio frequency connector (also referred to as a cable connector). This embodiment is described by using an example in which the first connector 81 is a BTB connector. This cannot be considered to constitute a special limitation on this application. Based on this, specifically, the first connector 81 may be a plug-in BTB connector, a contact BTB connector, or a magnetic BTB connector. This embodiment is described by using an example in which the first connector 81 is a plug-in BTB connector. The first connector 81 is electrically connected to another electronic component by using the circuit board 8.

The second connector 82 is located between the first connector 81 and the battery cover 4, and the second connector 82 is connected to the first connector 81 in a mating manner. The second connector 82 may also be a BTB connector or a radio frequency connector. This embodiment is described by using an example in which the second connector 82 is a BTB connector. Based on this, the second connector 82 may be a plug-in BTB connector, a contact BTB connector, or a magnetic BTB connector. This embodiment is described by using an example in which the second connector 82 is a plug-in BTB connector.

In some embodiments, continue to refer to FIG. 4. The second connector 82 may be a connector of the inner screen camera 6.

Specifically, continue to refer to FIG. 4. The inner screen camera 6 may include a camera body 61, the second connector 82, and an electrical connection structure 62. The camera body 61 is configured to implement video and image shooting. The second connector 82 is configured to implement detachable connection between the camera body 61 and another electronic component. The electrical connection structure 62 is connected between the camera body 61 and the second connector 82. In some embodiments, the circuit lead-out structure 62 may be a flexible printed circuit (flexible printed circuit, FPC), or may be a structure formed through weaving of a conducting wire and a flexible material. This is not specifically limited in this application.

In some embodiments, the second connector 82 includes a connector body 821 configured to be connected to the first connector 81 in a mating manner and a support base 822 configured to support the connector body 821. The support base 822 is configured to support the connector body 821, to enhance structural strength of the connector body 821, thereby facilitating connection between the connector body 821 and the first connector 81.

In some embodiments, the connector body 821 is disposed on a side of the electrical connection structure 62. The inner screen camera 6 further includes a reinforcement plate. The reinforcement plate is located on a side that is of the electrical connection structure 62 and that faces away from the connector body 821, and is stacked with the electrical connection structure 62. Optionally, an orthographic projection of the connector body 821 on the reinforcement plate is located in the reinforcement plate. In this way, the reinforcement plate and a part that is of the electrical connection structure 62 and that is stacked with the reinforcement plate form the support base 822. A structure of the support base 822 is simple, thereby facilitating electrical connection and assembly.

Certainly, when the second connector 82 is a connector in another structural form, the support base 822 may also have another structural form. This is not specifically limited herein.

In the foregoing embodiment, continue to refer to FIG. 4. The camera body 61 has a light-incident surface, and the light-incident surface of the camera body 61 is the light-incident surface of the inner screen camera 6. The light-incident surface of the camera body 61 is opposite to the second light transmission port C2 on the first screen 1.

Based on this, in some embodiments, continue to refer to FIG. 4. An avoidance opening K is disposed on each of the circuit board 8 and the second middle frame 22, and the camera body 61 is accommodated in the avoidance opening K. In this way, thicknesses of the camera body 61, the circuit board 8, and the second middle frame 22 may be prevented from be accumulated, thereby facilitating reduction of a thickness of the electronic device 10, and implementing thinning of the electronic device 10.

In some other embodiments, the second connector 82 may alternatively be a connector of a flash, a connector of the rear-facing camera 7, a connector of the outer screen camera 5, or a connector of an electrical connection structure between the circuit board in a first cavity and the circuit board 8 in a second cavity. This is not specifically limited in this application.

The press-fit bracket 83 is located between the second connector 82 and the battery cover 4. The press-fit bracket 83 is configured to limit the second connector 82 to prevent the second connector 82 from being separated from the first connector 81.

It should be noted that in addition to being disposed between the second connector 82 and the battery cover 4, the press-fit bracket 83 may be disposed between another component on the circuit board 8 and the battery cover, for example, disposed between a shielding cover and the battery cover 4.

In some embodiments, the press-fit bracket 83 may be connected to the circuit board 8. Specifically, the press-fit bracket 83 may be connected to the circuit board 8 in a manner of threaded connection, snap-fit, riveting, adhesive bonding, and the like.

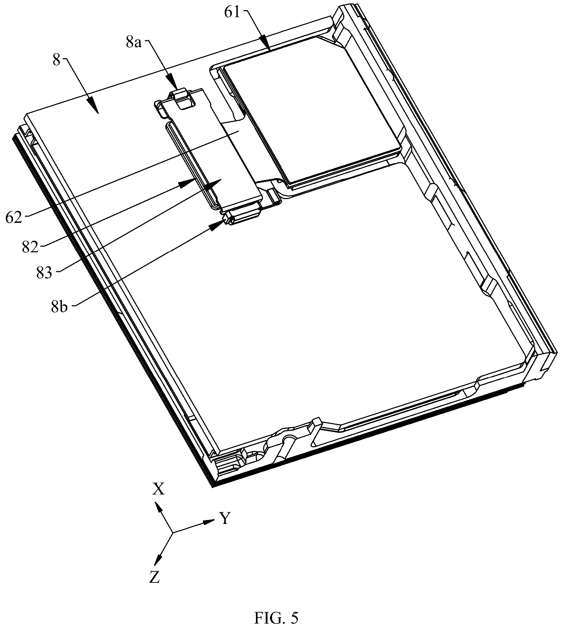

In some embodiments, refer to FIG. 5. FIG. 5 is an assembly diagram of the circuit board 8, the first connector 81, the second connector 82, and the press-fit bracket 83 in the electronic device 10 shown in FIG. 4. A snap-fit member 8a and a limiting member 8b are disposed on the circuit board 8.

One end of the press-fit bracket 83 mates with the snap-fit member 8a for limiting, and the other end of the press-fit bracket 83 mates with and is in snap-fit with the limiting member 8b, to implement connection between the press-fit bracket 83 and the circuit board 8. Therefore, a connection manner is snap-fit, a snap-fit operation is simple, and detachment is convenient.

A material of the press-fit bracket 83 includes but is not limited to a metallic material, for example, iron, copper, aluminum, stainless steel, copper alloy, aluminum alloy, magnesium aluminum alloy, or titanium alloy, or a non-metallic material, for example, polycarbonate (polycarbonate, PC), PC+ glass fiber, or ABS plastic (acrylonitrile butadiene styrene plastic). This is not specifically limited in this application.

Based on any embodiment described above, refer back to FIG. 4. The electronic device 10 further includes a heating component 9. The heating component 9 is located on the side that is of the second surface S2 and that faces away from the first surface S1. Specifically, the heating component 9 may be accommodated in the second accommodating cavity.

The heating component 9 may be an electronic component (that is, a heat source component) that generates heat during operation. For example, the heating component 9 may be a processor, a memory, a BTB connector, a cable connector, or the like.

Certainly, in another embodiment, the heating component 9 may alternatively be a structural member that transmits heat. For example, the heating component 9 may be a component that is in direct or indirect thermal contact with the heat source component, for example, the shielding cover. This is not specifically limited in this application.

In some embodiments, continue to refer to FIG. 4. The heating component 9 may be the second connector 82. When the second connector 82 operates, heat is generated at a contact point between the second connector 82 and the first connector 81 by a current, resulting in a temperature rise of the second connector 82. In addition, heat of the circuit board 8 may also be transmitted from the first connector 81 to the second connector 82, resulting in a temperature rise of the second connector 82.

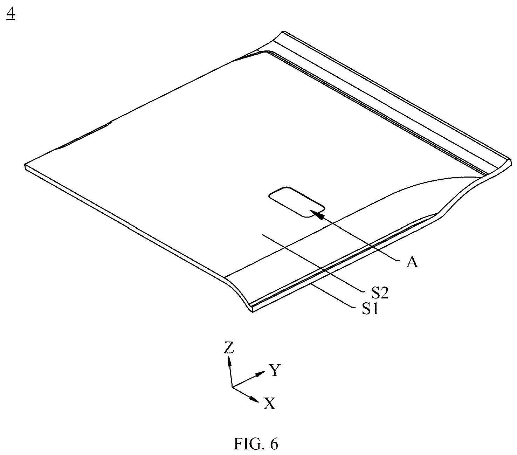

Based on this, refer to FIG. 4 and FIG. 6. FIG. 6 is a schematic diagram of a structure of the battery cover 4 at the second surface S2 in the electronic device 10 shown in FIG. 4. At least one groove A is disposed on the second surface S2 of the battery cover 4. "At least one" means one or more. In the embodiment shown in FIG. 4 and FIG. 6, there is one groove A. Such a structure is simple with low processing costs and complexity.

A shape of the groove A includes but is not limited to a circular shape, an elliptical shape, a rectangular shape, a triangular shape, a rhombic shape, and a polygonal shape. FIG. 6 illustrates an example in which the groove A is approximately in a rectangular shape. This cannot be considered as a special limitation on the shape of the groove A.

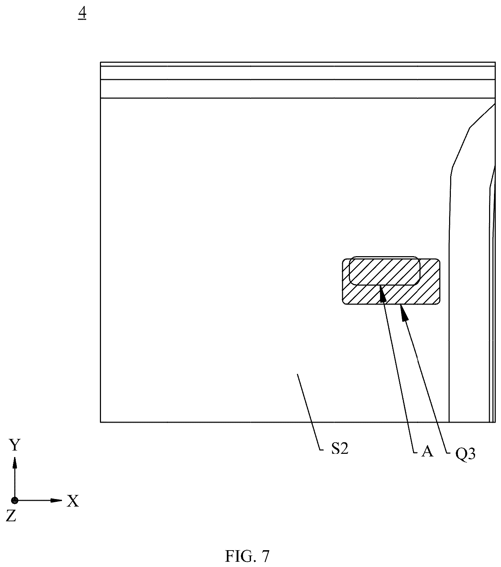

Refer to FIG. 7. FIG. 7 is a schematic diagram of a position of a region occupied by the groove A on the second surface S2 relative to an orthographic projection region of the heating component 9 on the second surface S2 in the electronic device shown in FIG. 4. It is assumed that the orthographic projection region of the heating component 9 on the second surface S2 is a third region Q3, and the region occupied by the groove A on the second surface S2 overlaps with the third region Q3.

It should be noted that, in this embodiment, an orthographic projection of a component on a surface represents a projection of this component on this surface in a direction perpendicular to this surface. For example, in this embodiment, an orthographic projection of the heating component 9 on the second surface S2 represents a projection of the heating component 9 on the second surface S2 in a direction perpendicular to the second surface S2.

In addition, it should be noted that, in this embodiment of this application, "two regions overlap with each other" means that a part of one of the two regions overlaps with the entirety of the other region, a part of this region overlaps with a part of the other region, the entirety of this region overlaps with a part of the other region, and the entirety of this region overlaps with the entirety of the other region.

In this way, the groove A is located on a shortest heat dissipation path from the heating component 9 to the battery cover 4. A sidewall of the groove A may implement a support function, thereby preventing a bottom wall of the groove A from being deformed toward the heating component 9 under the action of pressing during holding by a user. Therefore, a heat conduction path is prevented from being formed on the shortest heat dissipation path, and heat of the heating component 9 is prevented from being directly transmitted to the battery cover along the heat conduction path. Therefore, a possibility of generating a local hotspot on the battery cover 4 is reduced, and tactile feel and usage comfort of the electronic device 10 are improved. In addition, heat dissipation uniformity and heat dissipation efficiency of the electronic device 10 may be further improved by reducing the possibility of generating the local hotspot on the battery cover 4. It is verified by an experiment that, for the electronic device 10 shown in FIG. 4, compared with a solution in which no groove A is disposed, the solution in which the groove A is disposed can improve a heat dissipation capability by about 0.9 mA/°C.

Based on the foregoing embodiment, when the heating component 9 is the second connector 82, because a height by which a connector assembly including the first connector 81 and the second connector 82 protrudes from the circuit board 8 is large, and a distance between the second connector 82 and the battery cover 4 is short, the shortest heat dissipation path has a small length, and heat of the second connector 82 is easily transmitted to the battery cover 4. In addition, because an area occupied by the connector assembly including the first connector 81 and the second connector 82 on the circuit board 8 is small, the heat of the second connector 82 is easily concentrated and transmitted to a local region of the battery cover 4, resulting in the local hotspot on the battery cover 4. Consequently, the local region of the battery cover becomes hot to the touch, and tactile feel and usage comfort of the electronic device are affected. Based on this, the groove A may be used to effectively prevent the heat of the second connector 82 from being transmitted to the battery cover 4, thereby effectively reducing a risk that the local hotspot occurs on the battery cover 4, and effectively improving heat dissipation uniformity.

In some embodiments, continue to refer to FIG. 7. A part of the region occupied by the groove A on the second surface S2 is located in the third region Q3, and the other part of the region occupied by the groove A on the second surface S2 is located outside the third region Q3. In this way, a part of the battery cover that forms an edge of the groove A or a part of the ring-shaped flange that forms an edge of the groove A is only partially or is not located on the shortest heat dissipation path from the heating component 9 to the battery cover 4. Under the action of a pressure of the user, only a small amount of heat or virtually no heat is transmitted along the shortest heat dissipation path. Therefore, the local hotspot can be effectively prevented from being generated on the battery cover 4.

Based on any embodiment described above, optionally, refer back to FIG. 4. A first thermal insulator may be disposed in the groove A. The first thermal insulator includes but is not limited to at least one of air, thermal insulation silicone rubber, thermal insulation gel, glass wool, and polyurethane. In the embodiment shown in FIG. 4, the first thermal insulator is air.

In this way, thermal conductance of the first thermal insulator is low, which can prevent the heat of the heating component 9 from being transmitted to the battery cover 4 along the shortest heat dissipation path, thereby reducing the possibility of generating the local hotspot on the battery cover 4, and improving heat dissipation uniformity and a heat dissipation effect.

In some embodiments, thermal conductivity of the first thermal insulator is less than thermal conductivity of the battery cover 4. In this way, the thermal conductivity of the first thermal insulator is low, which can effectively prevent the heat of the heating component 9 from being transmitted to the battery cover 4 along the shortest heat dissipation path.

Based on any embodiment described above, the groove A may be recessed inward on the battery cover 4 or may be formed outside the battery cover 4.

In some embodiments, refer to FIG. 4 and FIG. 6. The at least one groove A is formed through recession of the second surface S2 toward the first surface S1. In this way, the groove A is recessed inward on the battery cover 4. Therefore, an internal space of the battery cover 4 is used to form an air thermal insulation layer, to avoid accumulation of thicknesses of the air thermal insulation layer and the battery cover 4, thereby facilitating thinning of a thickness of the electronic device 10.

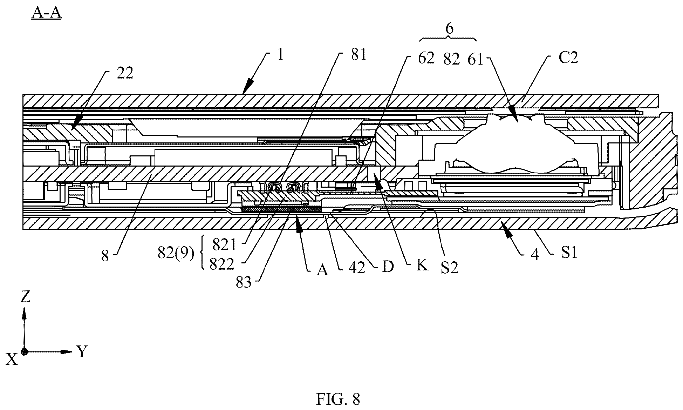

In some other embodiments, refer to FIG. 8. FIG. 8 is a schematic diagram of still another cross-sectional structure of the electronic device 10 shown in FIG. 1 in a direction A-A. In this embodiment, the electronic device 10 further includes at least one ring-shaped flange 42. In the embodiment shown in FIG. 8, there is one ring-shaped flange 42.

The ring-shaped flange 42 may be in a shape of a circular ring, an elliptical ring, a square ring, a triangular ring, a polygonal ring, or the like. This is not specifically limited in this application.

A material of the ring-shaped flange 42 may be a non-metallic material, for example, mylar (mylar), PC, PC+ glass fiber, or ABS plastic, or may be a metallic material, for example, aluminum alloy, copper alloy, or stainless steel.

The at least one ring-shaped flange 42 is disposed on the second surface S2, and the at least one ring-shaped flange 42 protrudes from the second surface S2 in a direction away from the first surface S1.

Specifically, the ring-shaped flange 42 may be fastened to the second surface S2 by using adhesive or may be integrally formed with the battery cover 4. This is not specifically limited in this application.

A partial space enclosed by the ring-shaped flange 42 and a part that is of the battery cover and that is surrounded by the ring-shaped flange 42 forms the groove A.

In this way, the groove A is disposed outside the battery cover 4, to prevent the groove A from affecting structural strength of the battery cover 4.

In some other embodiments, the groove A may further include a first groove part and a second groove part. The first groove part is formed through recession of the second surface S2 toward the first surface S1. The second groove part is formed by a partial space surrounded by the ring-shaped flange 42. The second groove part is opposite to and in communication with the first groove part. In this way, on a premise that the groove A has a specific depth, a depth of a part of the groove A inside the battery cover 4 is small, thereby ensuring structural strength of the battery cover 4. In addition, a distance by which the ring-shaped flange 42 protrudes from the second surface S2 is small, so that an accumulated thickness can be reduced, thereby facilitating thinning of the thickness of the electronic device 10.

It can be learned that the depth of the groove A affects a support effect of the sidewall of the groove A. Specifically, a larger depth of the groove A indicates a better support effect of the sidewall of the groove A, and therefore, the bottom wall of the groove can be better prevented from being deformed toward the heating component under the action of pressing during holding by the user. In addition, when the groove A is recessed inward on the battery cover 4, the depth of the groove A further affects structural strength of the battery cover 4. Specifically, a larger depth of the groove A indicates smaller structural strength of the battery cover 4. When the sidewall of the groove A is formed by the ring-shaped flange 42, the depth of the groove A further affects the thickness of the electronic device 10. Specifically, a larger depth of the groove A indicates a larger height by which the ring-shaped flange 42 protrudes from the second surface S2, a larger accumulated thickness of the groove A and the battery cover 4, and a larger thickness of the electronic device 10, making it more challenging to implement thinning of the electronic device 10.

Based on this, optionally, the depth of the groove A may be greater than or equal to 0.01 millimeter (mm) and less than or equal to 0.4 mm. Specifically, the depth of the groove A may be 0.01 mm, 0.05 mm, 0.08 mm, 0.1 mm, 0.2 mm, 0.3 mm, or 0.4 mm. When the depth of the groove A is within this range, a height of the sidewall of the groove A is moderate, so that an effective support function can be implemented, to prevent the bottom wall of the groove A from being deformed toward the heating component under the action of pressing during holding by the user. In addition, when the groove A is recessed inward on the battery cover 4, the depth for inward recession of the groove A is moderate, and structural strength of the battery cover 4 is good. When the sidewall of the groove A is formed by the ring-shaped flange 42, a height by which the ring-shaped flange 42 protrudes from the second surface S2 is moderate, and the accumulated thickness of the groove A and the battery cover 4 is moderate, thereby facilitating thinning of the thickness of the electronic device 10.

It can be learned that an area of the groove A affects a thermal insulation effect of the air thermal insulation layer. Specifically, a larger area of the groove A indicates a larger area of the air thermal insulation layer in the groove A, and a better thermal insulation effect. In addition, when the groove A is recessed inward on the battery cover 4, the area of the groove A further affects structural strength of the battery cover 4. Specifically, a larger area of the groove A indicates smaller structural strength of the battery cover 4. In this case, the groove A of the battery cover 4 is easily bent toward the heating component 9 under the action of an external pressure, causing the battery cover 4 to be in thermal contact with the heating component 9. Consequently, local heat of a pressing part of the battery cover 4 is large, which affects hand feel. The external pressure may be a holding pressure when the electronic device is held. When the sidewall of the groove A is formed by the ring-shaped flange 42, the area of the groove A further affects a support effect of the ring-shaped flange 42 on the battery cover 4. Specifically, a larger area of the groove A indicates a poorer support effect of the ring-shaped flange 42 on the battery cover 4. In this case, the part that is of the battery cover 4 and that is surrounded by the ring-shaped flange 42 is easily bent toward the heating component 9 under the action of the external pressure, causing the battery cover 4 to be in thermal contact with the heating component 9. Consequently, local heat of a pressing part of the battery cover 4 is large, which affects tactile feel of the electronic device.

Based on this, optionally, it is assumed that an orthographic projection area of the heating component 9 on the second surface S2 (that is, an area of the third region Q3) is a first area, and an area occupied by the groove A on the second surface S2 is a second surface. The second area is greater than or equal to 1/10 times the first area, and is less than or equal to 5 times the first area. Specifically, the second area may be 1/10, 1/5, 1, 2, 3, 4, or 5 times the first area. In this way, the area of the groove A is moderate, thereby effectively ensuring a thermal insulation effect and improving tactile feel of the electronic device.

Based on any embodiment described above, when the press-fit bracket 83 is disposed between the heating component 9 and the battery cover 4, specifically, the orthographic projection of the heating component 9 on the second surface S2 overlaps with an orthographic projection of the press-fit bracket 83 on the second surface S2. Based on this, the part of the battery cover 4 that forms the edge of the groove A or the part of the ring-shaped flange 42 that forms the edge of the groove A may be at least partially supported on the press-fit bracket 83 to form stable support for the battery cover 4. Therefore, the battery cover 4 is prevented from being bent toward the heating component 9 under the action of the external pressure, and the battery cover 4 is prevented from being in thermal contact with the heating component 9.

Specifically, in some embodiments, it is assumed that the region occupied by the groove A on the second surface S2 is a first region Q1, and an orthographic projection region of the press-fit bracket 83 on the second surface S2 is a second region Q2. At least a partial section of a contour of the first region Q1 is located in the second region Q2, and is spaced from a contour of the second region Q2.

In this way, the part of the battery cover 4 that forms the edge of the groove A or the part of the ring-shaped flange 42 that forms the edge of the groove A may be at least partially supported on the press-fit bracket 83 to form stable support for the battery cover 4, thereby preventing the battery cover 4 from being bent toward the heating component 9 under the action of the external pressure, and preventing the battery cover 4 from being in thermal contact with the heating component 9.

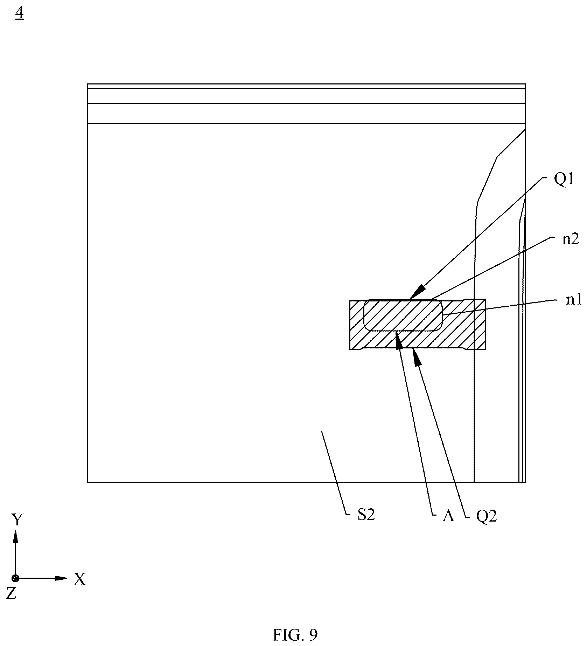

In some embodiments, refer to FIG. 9. FIG. 9 is a schematic diagram of a position of a region occupied by the groove A on the second surface S2 relative to an orthographic projection region of the press-fit bracket 83 on the second surface S2 in the electronic device shown in FIG. 4. A partial section of the contour of the first region Q1 is located in the second region Q2 and is spaced from the contour of the second region Q2. Still another partial section of the contour of the first region Q1 is located outside the second region Q2 and is spaced from the contour of the second region Q2. In this way, the part of the battery cover that forms the edge of the groove A or the part of the ring-shaped flange that forms the edge of the groove A is only partially located on a shortest heat dissipation path from the press-fit bracket 83 to the battery cover 4. Under the action of the pressure of the user, only a small amount of heat is transmitted along the shortest heat dissipation path from the press-fit bracket 83 to the battery cover 4. Therefore, the local hotspot can be effectively prevented from being generated on the battery cover 4. In addition, the groove A and the press-fit bracket 83 may be prevented from enclosing a closed space, thereby preventing internal air from being expanded due to heating, and further avoiding a local defect on the battery cover 4.

For example, continue to refer to FIG. 9. The contour of the first region Q1 includes a first section n1 and a second section n2. The first section n1 is located in the second region Q2, and is spaced from the contour of the second region Q2. The second section n2 is located outside the second region Q2. Both the first section n1 and the second section n2 do not include intersection points between the contour of the first region Q1 and the contour of the second region Q2.

In this way, a part of the battery cover 4 that forms the first section n1 or a part of the ring-shaped flange 42 that forms the first section n1 may be supported on the press-fit bracket 83 to form stable support for the battery cover 4, thereby preventing the battery cover 4 from being bent toward the heating component 9 under the action of the external pressure. In addition, because the second section n2 is located outside the second region Q2, a part of the battery cover that forms the second section n2 or a part of the ring-shaped flange that forms the second section n2 is not located on the shortest heat dissipation path from the press-fit bracket 83 to the battery cover 4. Under the action of the pressure of the user, only a small amount of heat is transmitted along the shortest heat dissipation path from the press-fit bracket 83 to the battery cover 4. Therefore, the local hotspot can be effectively prevented from being generated on the battery cover 4.

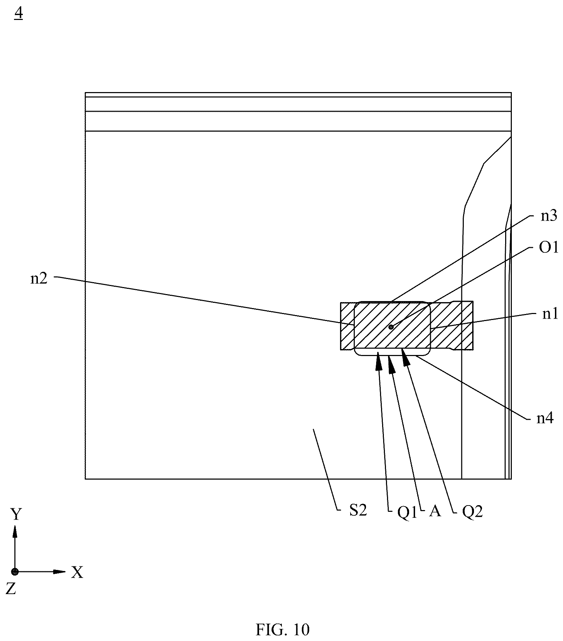

For another example, refer to FIG. 10. FIG. 10 is a schematic diagram of still another position of a region occupied by the groove A on the second surface S2 relative to an orthographic projection region of the press-fit bracket 83 on the second surface in the electronic device shown in FIG. 4. In this embodiment, the contour of the first region Q1 includes a first section n1 and a second section n2. A geometric center of the first region Q1 is a center O1, and the first section n1 and the second section n2 are located on two opposite sides of the center O1. In addition, the first section n1 and the second section n2 are located in the second region Q2, and are spaced from the contour of the second region Q2. When the contour of the first region Q1 intersects with the contour of the second region Q2, both the first section n1 and the second section n2 do not include intersection points between the contour of the first region Q1 and the contour of the second region Q2.

In this way, two parts of the battery cover 4 that respectively form the first section n1 and the second section n2 or two parts of the ring-shaped flange 42 that respectively form the first section n1 and the second section n2 may be supported on the press-fit bracket 83. In addition, because the first section n1 and the second section n2 are located on the two opposite sides of the center O1, the two parts of the battery cover 4 that respectively form the first section n1 and the second section n2 or the two parts of the ring-shaped flange 42 that respectively form the first section n1 and the second section n2 are also located on the two opposite sides of the center O1, so that a support force for the battery cover 4 is more balanced, thereby effectively preventing the battery cover 4 from being bent toward the heating component 9 under the action of the external pressure.

Based on the foregoing embodiment, sections other than the first section n1 and the second section n2 in the contour of the first region Q1 may be located in the second region Q2 or outside the second region Q2.

In some embodiments, continue to refer to FIG. 10. In addition to the first section n1 and the second section n2, the contour of the first region Q1 further includes a third section n3 and a fourth section n4. The third section n3 is connected between one end of the first section n1 and one end of the second section n2. The fourth section n4 is connected between the other end of the first section n1 and the other end of the second section n2. Both the third section n3 and the fourth section n4 are located outside the second region Q2.

In this way, a part of the contour of the first region Q1 extends beyond the second region Q2. Therefore, on a premise that the press-fit bracket 83 has a specific area, a region area of the first region Q1 may be designed to be large, thereby increasing the area of the air thermal insulation layer in the groove A, and ensuring the thermal insulation effect.

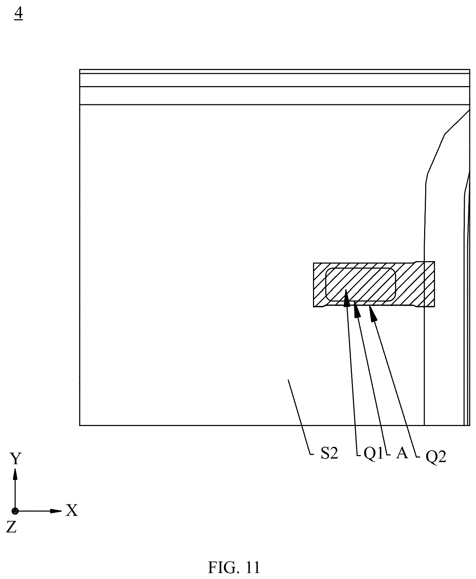

In some other embodiments, refer to FIG. 11. FIG. 11 is a schematic diagram of still another position of a region occupied by the groove A on the second surface S2 relative to an orthographic projection region of the press-fit bracket 83 on the second surface in the electronic device shown in FIG. 4. In this embodiment, the first region Q1 is located in the second region Q2, and the contour of the first region Q1 is spaced from the contour of the second region Q2. That is, the first section n1, the second section n2, the third section n3, and the fourth section n4 are located in the second region Q2.

In this way, the part of the battery cover 4 that forms the edge of the groove A or the part of the ring-shaped flange 42 that forms the edge of the groove A is entirely supported on the press-fit bracket 83, to achieve a good support effect on the battery cover 4, thereby effectively preventing the battery cover 4 from being bent toward the heating component 9 under the action of the external pressure, and effectively ensuring the thermal insulation effect.

In some embodiments, at least one flange (not shown in the figure) may be disposed at a bottom surface of the groove A. The flange may extend along a straight line, a curved line, or a ring-shaped line. This is not specifically limited in this application. The at least one flange may be used to further implement the support function, thereby preventing the bottom wall of the groove A from being deformed toward the heating component 9 under the action of pressing during holding by the user.

The foregoing embodiments are described by using an example in which there is one groove A. In another embodiment, there may be a plurality of grooves A.

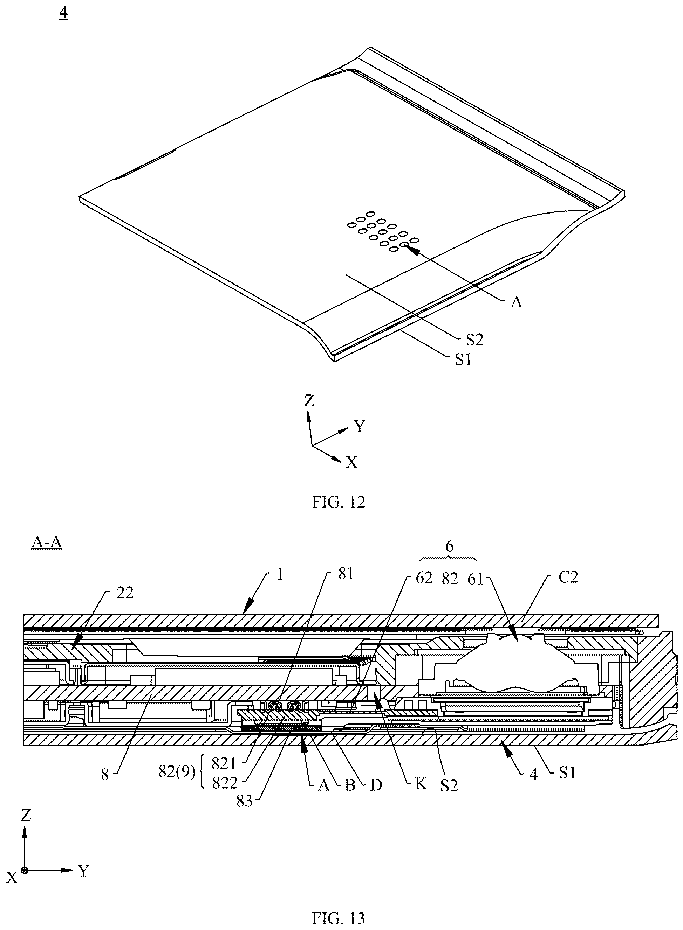

For example, refer to FIG. 12. FIG. 12 is a schematic diagram of still another structure of the battery cover 4 at the second surface S2 in the electronic device 10 shown in FIG. 4. In this embodiment, there are a plurality of grooves A, and the plurality of grooves A are arrayed on the second surface S2.

In this way, on a premise that a preset region on the second surface S2 for disposing the grooves A has a specific area, when the plurality of grooves A are disposed in the preset region, an area occupied by each groove A on the second surface S2 is small. When the groove A is recessed inward on the battery cover 4, compared with a solution in which one groove A is disposed in the preset region, the solution in which the plurality of grooves A are disposed can ensure structural strength of the battery cover 4 because a volume occupied by the grooves A in the battery cover 4 is small. When the sidewall of the groove A is formed by the ring-shaped flange 42, a quantity of ring-shaped flanges 42 is large, so that support performance for the battery cover 4 is good, thereby effectively preventing the battery cover 4 from being bent toward the heating component 9 under the action of the pressure.

In the foregoing embodiment, areas occupied by the plurality of grooves A on the second surface S2 may be equal or unequal. FIG. 12 illustrates an example in which the areas occupied by the plurality of grooves A on the second surface S2 are equal.

In some other embodiments, as described above, the orthographic projection region of the heating component 9 on the second surface S2 is the third region Q3, and a geometric center of the third region Q3 is a second center. The plurality of grooves A include a first groove, and the second center is located in a region occupied by the first groove on the second surface S2. Based on this, an area of the first groove may be designed to be large, and areas of other grooves around the first groove may be designed to be small, to ensure thermal insulation uniformity and effectively avoid heat concentration.

The foregoing embodiments are described by using an example in which the first thermal insulator is air. In another embodiment, the first thermal insulator may alternatively be a solid thermal insulation material.

For example, refer to FIG. 13. FIG. 13 is a schematic diagram of still another cross-sectional structure of the electronic device 10 shown in FIG. 1 in a direction A-A. In this embodiment, the first thermal insulator is a solid thermal insulation material B. The solid thermal insulation material B includes but is not limited to thermal insulation silicone rubber, thermal insulation gel, glass wool, and polyurethane.

Specifically, the solid thermal insulation material B may be fastened in the groove A in a manner of adhesive bonding, snap-fit, or threaded connection, or may be directly formed in the groove A. This is not specifically limited in this application.

In this way, on the one hand, the solid thermal insulation material B forms a thermal insulation layer, and the thermal insulation layer can prevent the heat of the heating component 9 from being transmitted to the battery cover 4, thereby reducing the possibility of generating the local hotspot on the battery cover 4 to some extent, and improving heat dissipation uniformity and heat dissipation efficiency. On the other hand, when the groove A is recessed inward on the battery cover 4, the solid thermal insulation material B may compensate for structural strength of the battery cover 4 to some extent, to reduce a bending deformation amount at the groove A of the battery cover 4 toward the heating component 9 under the action of the external pressure. When the sidewall of the groove A is formed by the ring-shaped flange 42, the solid thermal insulation material B may be used to improve structural strength of the battery cover 4, thereby preventing the groove A of the battery cover 4 from being bent toward the heating component 9 under the action of the external pressure.

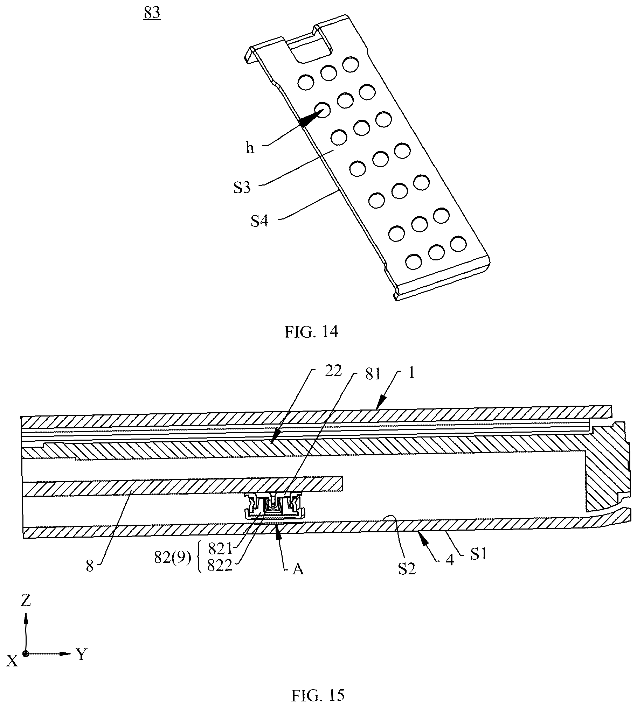

Based on any embodiment described above, when the press-fit bracket 83 is disposed between the heating component 9 and the battery cover 4, to further improve the thermal insulation effect on the heating component 9, in some embodiments, refer to FIG. 14, FIG. 14 is a schematic diagram of a structure of a press-fit bracket 83 according to some embodiments of this application. A surface that is of the press-fit bracket 83 and that faces the battery cover 4 is defined as a third surface S3, and a surface that is of the press-fit bracket 83 and that faces the heating component 9 is defined as a fourth surface S4. Based on this, at least one thermal insulation through hole h may be disposed on the press-fit bracket 83, and the thermal insulation through hole h runs through the third surface S3 and the fourth surface S4. A shape of the thermal insulation through hole h includes but is not limited to a circular shape, an elliptical shape, a rectangular shape, a triangular shape, a rhombic shape, and a polygonal shape. FIG. 14 illustrates an example in which the thermal insulation through hole h is in a circular shape. This cannot be considered as a special limitation on the shape of the thermal insulation through hole h.

In this way, the at least one thermal insulation through hole h may be used to further prevent the heat of the heating component 9 from being transmitted to the battery cover 4, thereby further reducing the possibility of generating the local hotspot on the battery cover 4.

Based on the foregoing embodiment, optionally, a second thermal insulator may be disposed in the thermal insulation through hole h, and thermal conductivity of the second thermal insulator is less than thermal conductivity of the press-fit bracket 83. The second thermal insulator includes but is not limited to at least one of air, thermal insulation silicone rubber, thermal insulation gel, glass wool, and polyurethane. Thermal conductance of the second thermal insulator is low, which can prevent the heat of the heating component 9 from being transmitted to the battery cover 4, thereby reducing the possibility of generating the local hotspot on the battery cover 4, and improving heat dissipation uniformity and heat dissipation efficiency.

There may be one or more thermal insulation through holes h. In the embodiment shown in FIG. 14, there are a plurality of thermal insulation through holes h, and the plurality of thermal insulation through holes h are arrayed on the press-fit bracket 83. In this way, on a premise that a region on the press-fit bracket 83 for disposing the thermal insulation through holes h has a specific area, compared with a solution in which one thermal insulation through hole h is disposed, the solution in which the plurality of thermal insulation through holes h are disposed can ensure structural strength of the press-fit bracket 83 because an area for disposing each thermal insulation through hole h is small.

When there are a plurality of thermal insulation through holes h, the plurality of thermal insulation through holes h may have a same shape and a same size, or may have a same shape but different sizes. In the embodiment shown in FIG. 14, the plurality of thermal insulation through holes h have a same shape and a same size. In this way, difficulty of processing the thermal insulation through holes h is small, and consistency in appearances is good.

In some other embodiments, the plurality of thermal insulation through holes h may include a first thermal insulation hole, an orthographic projection of the first thermal insulation hole on the second surface S2 is a second projection, and the second center is located in the second projection. Based on this, an area of the first thermal insulation hole may be greater than an area of any of the plurality of thermal insulation through holes h. In this way, thermal insulation uniformity of the plurality of thermal insulation through holes h can be ensured, and heat concentration can be effectively avoided.

When there are a plurality of thermal insulation through holes h and the plurality of thermal insulation through holes h are arrayed on the third surface S3 or the fourth surface S4, if there are a plurality of grooves A and the plurality of grooves A are arrayed on the second surface S2, the plurality of thermal insulation through holes h may be respectively opposite to the plurality of grooves A. That is, orthographic projections of the plurality of thermal insulation through holes h on the second surface S2 respectively overlap with regions occupied by the plurality of grooves A on the second surface S2.

Certainly, in another embodiment, the orthographic projections of the plurality of thermal insulation through holes h on the second surface S2 may be arranged, in a staggered manner, with the regions occupied by the plurality of grooves A on the second surface S2. That is, geometric centers of the orthographic projections of the plurality of thermal insulation through holes h on the second surface S2 do not respectively overlap with geometric centers of the regions occupied by the plurality of grooves A on the second surface S2, and at least a part of the orthographic projection of the thermal insulation through hole h on the second surface S2 is located outside the region occupied by the groove A on the second surface S2. In this way, an area of a thermal insulation layer is greater than a sum of areas of the plurality of thermal insulation through holes h, and the area of the thermal insulation layer is further greater than a sum of areas of the plurality of grooves A. Therefore, the area of the thermal insulation layer can be increased, and thermal insulation performance can be improved.

In some embodiments, the orthographic projection of the thermal insulation through hole h on the second surface S2 may be entirely located outside the region occupied by the groove A on the second surface S2. In this way, an area of a thermal insulation layer is a sum of areas of the plurality of thermal insulation through holes h and areas of the plurality of grooves A. Therefore, the area of the thermal insulation layer can be maximized by using the plurality of grooves A and the plurality of thermal insulation through holes h, and thermal insulation performance can be improved. In addition, density for disposing the grooves A on the battery cover 4 may be small, and density for disposing the thermal insulation through holes h on the press-fit bracket 83 may be small, so that structural strength of the battery cover 4 and the press-fit bracket 83 can be ensured.

In some other embodiments, at least one thermal insulation blind hole may be disposed on the third surface S3 or the fourth surface S4. The at least one thermal insulation blind hole may also be used to prevent the heat of the heating component 9 from being transmitted to the battery cover 4, thereby further reducing the possibility of generating the local hotspot on the battery cover 4. In addition, the thermal insulation blind hole does not run through the press-fit bracket 83, thereby ensuring structural strength of the press-fit bracket 83.

In some embodiments, refer back to FIG. 4. A heat sink D is further disposed between the press-fit bracket 83 and the groove A. A material of the heat sink D includes but is not limited to a material with high thermal conductivity, for example, copper, copper alloy, graphite, and graphene. An orthographic projection area of the heat sink D on the second surface S2 is greater than the area of the region occupied by the groove A on the second surface S2. In this way, the heat sink D may be used to transmit, along an XY plane, the heat of the heating component 9 outward beyond a region in which the groove A is located, to prolong a thermal conduction path, thereby avoiding heat concentration, preventing the local hotspot from being generated on the battery cover 4, improving heat dissipation uniformity, and implementing good heat dissipation performance.

The foregoing embodiments are described by using an example in which the first connector 81 and the second connector 82 are BTB connectors. In another embodiment, the first connector 81 and the second connector 82 may alternatively be radio frequency connectors.

For example, refer to FIG. 15. FIG. 15 is a schematic diagram of a cross-sectional structure of an electronic device 10 according to still some embodiments of this application. In this embodiment, the first connector 81 and the second connector 82 are radio frequency connectors configured to transmit radio frequency signals.

Based on this, the second connector 82 may form the heating component 9, and the groove A may also be disposed at a position that is on the second surface S2 of the battery cover 4 and that is opposite to the second connector 82. Therefore, heat concentration is avoided at a part that is of the battery cover 4 and that is opposite to the radio frequency connector, and heat dissipation uniformity and a heat dissipation capability of the electronic device are improved.

In the descriptions of this specification, specific features, structures, materials, or characteristics may be properly combined in any one or more embodiments or examples.

Finally, it should be noted that the foregoing embodiments are only used to describe the technical solutions in this application, but are not used to limit this application. Although this application has been described in detail with reference to the foregoing embodiments, it should be understood by a person of ordinary skill in the art that the technical solutions described in the foregoing embodiments may still be modified, or some technical features thereof may be equivalently replaced. These modifications or replacements do not make the essence of the corresponding technical solutions depart from the spirit and scope of the technical solutions in the embodiments of this application.

## Claims

1. An electronic device, comprising:
a battery cover, wherein the battery cover comprises a first surface and a second surface, the first surface forms a partial region of an outer surface of the electronic device, and the second surface faces away from the first surface; and
a heating component, wherein the heating component is located on a side that is of the second surface and that faces away from the first surface; and
at least one groove is disposed on the second surface, and a region occupied by the groove on the second surface overlaps with an orthographic projection region of the heating component on the second surface.

2. The electronic device according to claim 1, wherein a first thermal insulator is disposed in the groove.

3. The electronic device according to claim 2, wherein thermal conductivity of the first thermal insulator is less than thermal conductivity of the battery cover.

4. The electronic device according to any one of claims 1-3, further comprising:
a circuit board, wherein the circuit board is located on a side that is of the second surface and that is away from the first surface;
a first connector, wherein the first connector is disposed on a surface that is of the circuit board and that faces the battery cover; and
a second connector, wherein the second connector is located between the first connector and the battery cover and is connected to the first connector in a mating manner, and the second connector forms the heating component.

5. The electronic device according to any one of claims 1-4, wherein the groove is formed through recession of the second surface toward the first surface.

6. The electronic device according to any one of claims 1-4, further comprising:
at least one ring-shaped flange, wherein the at least one ring-shaped flange is disposed on the second surface, and a partial space enclosed by the ring-shaped flange and a part that is of the battery cover and that is surrounded by the ring-shaped flange forms the groove.

7. The electronic device according to any one of claims 1-6, wherein an orthographic projection area of the heating component on the second surface is a first area, and an area occupied by the groove on the second surface is a second area; and
the second area is greater than or equal to 1/10 times the first area, and is less than or equal to 5 times the first area.

8. The electronic device according to any one of claims 1-7, wherein there are a plurality of grooves, and the plurality of grooves are arrayed on the second surface.

9. The electronic device according to any one of claims 1-8, wherein a depth of the groove is greater than or equal to 0.01 mm, and is less than or equal to 0.4 mm.

10. The electronic device according to any one of claims 1-9, wherein a part of the region occupied by the groove on the second surface is located in the orthographic projection region of the heating component on the second surface, and the other part of the region occupied by the groove on the second surface is located outside the orthographic projection region of the heating component on the second surface.

11. The electronic device according to any one of claims 1-10, further comprising:
a press-fit bracket, wherein the press-fit bracket is located between the heating component and the battery cover, and the press-fit bracket is fixedly connected to the circuit board.

12. The electronic device according to claim 11, wherein the region occupied by the groove on the second surface is a first region, and an orthographic projection region of the press-fit bracket on the second surface is a second region; and
at least a partial section of a contour of the first region is located in the second region, and is spaced from a contour of the second region.

13. The electronic device according to claim 12, wherein a partial section of the contour of the first region is located in the second region and is spaced from the contour of the second region, and still another partial section of the contour of the first region is located outside the second region and is spaced from the contour of the second region.

14. The electronic device according to claim 12, wherein the contour of the first region comprises a first section and a second section, the first section and the second section are located on two opposite sides of a geometric center of the first region, and the first section and the second section are located in the second region and are spaced from the contour of the second region.

15. The electronic device according to claim 14, wherein the first region is located in the second region, and the contour of the first region is spaced from the contour of the second region.

16. The electronic device according to any one of claims 11-15, wherein at least one thermal insulation through hole is disposed on the press-fit bracket.

17. The electronic device according to claim 16, wherein a second thermal insulator is disposed in the thermal insulation through hole, and thermal conductivity of the second thermal insulator is less than thermal conductivity of the press-fit bracket.

18. The electronic device according to claim 16 or 17, wherein there are a plurality of thermal insulation through holes, and the plurality of thermal insulation through holes are arrayed on the press-fit bracket.

19. The electronic device according to claim 18, wherein there are a plurality of grooves, and the plurality of grooves are arrayed on the second surface; and
orthographic projections of the plurality of thermal insulation through holes on the second surface are arranged, in a staggered manner, with regions occupied by the plurality of grooves on the second surface.

20. The electronic device according to any one of claims 11-15, wherein at least one thermal insulation blind hole is disposed on a surface that is of the press-fit bracket and that faces the battery cover or a surface that is of the press-fit bracket and that faces the heating component.

21. The electronic device according to any one of claims 11-20, further comprising:
a heat sink, wherein the heat sink is disposed between the press-fit bracket and the groove, and an orthographic projection area of the heat sink on the second surface is greater than an area of the region occupied by the groove on the second surface.

22. The electronic device according to claim 21, wherein a material of the heat sink is graphite or graphene.

23. The electronic device according to claim 4, wherein the first connector and the second connector are BTB connectors or radio frequency connectors.

24. The electronic device according to claim 4, wherein the electronic device is a foldable mobile phone.

25. The electronic device according to claim 24, wherein the foldable mobile phone comprises an inner screen camera, and the second connector is a connector of the inner screen camera.
